Europäisches Patentamt

European Patent Office

Office européen des brevets

(19)

(11) **EP 1 653 525 A1**

(12) **EUROPEAN PATENT APPLICATION**
published in accordance with Art. 158(3) EPC

(43) Date of publication:
03.05.2006 Bulletin 2006/18

(51) Int Cl.:
*H01L 39/24* (1974.07)      *H01L 39/22* (1974.07)
*H01L 29/66* (1974.07)

(21) Application number: 04748204.7

(22) Date of filing: 03.08.2004

(86) International application number:
PCT/JP2004/011071

(87) International publication number:
WO 2005/015650 (17.02.2005 Gazette 2005/07)

(84) Designated Contracting States:
DE FR GB

(30) Priority: 07.08.2003  JP 2003206546

(71) Applicants:
• RIKEN
Wako-shi,
Saitama 351-0198 (JP)
• NEC CORPORATION
Minato-ku,
Tokyo 108-8001 (JP)

(72) Inventors:
• WATANABE, Michio;
c/o Riken
Wako-shi, Saitama 351-0198 (JP)
• NAKAMURA, Yasunobu;
c/o NEC Corporation
Minato-ku, Tokyo 108-8001 (JP)

(74) Representative: Schuster, Thomas et al
Grünecker, Kinkeldey, Stockmair &
Schwanhäusser
Anwaltssozietät
Maximilianstrasse 58
80538 München (DE)

(54) **METHOD OF MANUFACTURING MICRO TUNNEL-JUNCTION CIRCUIT AND MICRO TUNNEL-JUNCTION CIRCUIT**

(57)   A method of manufacturing a micro tunnel-junction circuit capable of remarkably relieving the limitation of a circuit pattern to be manufactured and remarkably relieving the limitation of a metallic material to be used. In the method, a three-layer structure is formed by laminating a first metal, an insulator, and a second metal on a substrate in this order, a narrow wall part is formed by cutting the three-layer structure in the depth direction by using a converging ion beam, at least one laterally passed through-hole is formed in the wall part by using the converging ion beam, and at least one recessed portion positioned adjacent to the hole is formed by cutting the upper surface of the wall part in the depth direction. The hole is a through-hole starting at the position of the head of the second metal to the position of the head of the substrate and the recessed part is formed to be recessed from the upper surface of the wall part into the first metal.

FIG. 7 (a)

# FIG. 7 (b)

**Description**

Technical Field

The present invention relates to a method of manufacturing a micro tunnel-junction circuit and a micro tunnel-junction circuit, more specifically to a method of manufacturing a micro tunnel-junction circuit and a micro tunnel-junction circuit, which are preferably used in manufacturing a micro tunnel-junction device such as a single-electron transistor.

Background Art

An electronic device provided with a micro tunnel-junction circuit such as a single-electron transistor is generally known as an electronic device for realizing charge measurement or quantum computation.
Charging effect by one electron becomes important when the size of tunnel-junction is made smaller in a sandwich structure where an insulator is sandwiched by metals such as a [metal-insulator-metal] structure, realization of a device having a totally different principle of operation from a conventional one is expected such that an electron is individually controlled by a Coulomb blockage phenomenon, and a single-electron transistor using a micro tunnel-junction circuit of a smaller tunnel-junction size has already been developed as described above.
As a metal used in such micro tunnel-junction circuit, normal conductor, superconductor, ferromagnetic or the like can be used (refer to Non-patent document 1 and Non-patent document 2) .

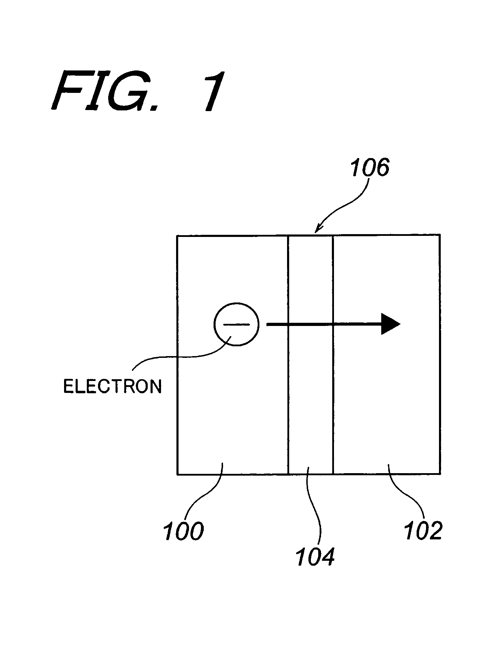

Herein, Fig. 1 shows the principle of the Coulomb blockade phenomenon caused by a micro tunnel-junction. In the case where a micro tunnel-junction 106 is formed by sandwiching an insulator 104 between the first metal 100 and the second metal 102, charging effect by one electron becomes important and the Coulomb blockade phenomenon where tunneling of electron is restricted occurs when the following holds.

$$E_C \equiv e^2/2C \gg k_B T$$

where

E_C:    Charging energy
e:      Elementary charge
C:      Electrostatic capacity of micro tunnel-junction
k_B:    Boltzman's constant
T:      Absolute temperature

Herein, when the junction area of the micro-tunnel junction 106 is a micro tunnel-junction of $0.1 \times 0.1 \mu m^2$, $E_c$ becomes an order of 1K.

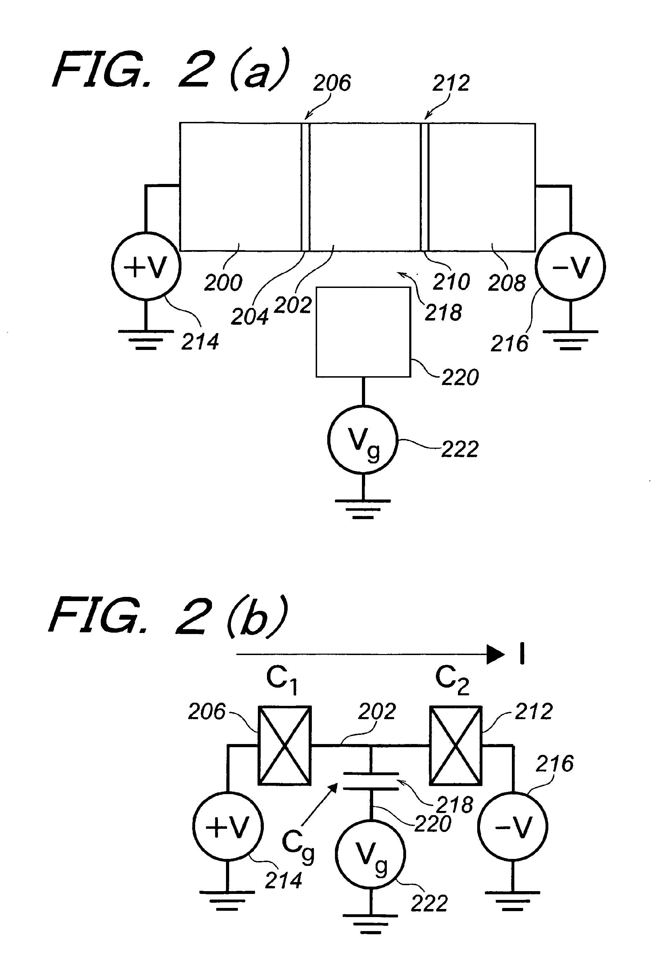

Fig. 2(a) shows a principle constitution view of a single-electron transistor provided with a micro tunnel-junction circuit constituted by the above-described micro tunnel-junction, and Fig. 2(b) shows an equivalent circuit of Fig. 2 (a) .

Description will be made referring to Fig. 2 (a), in which the single-electron transistor is that the first micro tunnel-junction 206 is constituted by sandwiching an insulator 204 with the first metal 200 and the second metal 202, and the second tunnel-junction 212 is constituted by sandwiching an insulator 210 with the second metal 202 and the third metal 208. Further, the transistor is provided with the first voltage source 214 applying bias voltage V to the first metal 200 and the second voltage source 216 applying minus bias voltage V to the third metal 208.

Furthermore, a gate electrode 220 is disposed adjacent to the second metal 202 so as to constitute a parallel plate capacitor 218 between the electrode and the second metal 202. Still further, the third voltage source 222 applying gate voltage $V_g$ to the gate electrode 220 is disposed.

Next, description will be made for the equivalent circuit of the single-electron transistor referring to Fig. 2 (b), in which the single-electron transistor is constituted by having the first micro tunnel-junction 206, the second micro tunnel-junction 212, the second metal 202, the gate electrode 220, the parallel plate capacitor 218, the first voltage source 214 , the second voltage source 216, and the third voltage source 222.

In the above-mentioned constitution, the bias voltage V and the gate voltage $V_g$ are set first by the first voltage source 214 , the second voltage source 216, and the third voltage source 222 to allow Coulomb blockage to work in both the first micro tunnel-junction 206 and the second micro tunnel-junction 212. Therefore, electric current I is not allowed to flow in the single-electron transistor under this state.

Next, as the gate voltage $V_g$ is increased, Coulomb blockage in the second micro tunnel-junction 212 is cancelled first and electrons tunnel to the second metal 202. At the same time, Coulomb blockage in the first micro tunnel-junction 206 is cancelled and electric current I is allowed to flow in the single-electron transistor.

Specifically, in the single-electron transistor that is constituted by having the double micro tunnel-junctions (the first micro tunnel-junction 206 and the second micro tunnel-junction 212) and the gate electrode 220, the followings are defined.

$$E_C = e^2/2 (C_1+C_2+C_g)$$

where

E_C:    Charging energy
e:      Elementary charge
C_1:    Electrostatic capacity of the first micro tunnel-junction 206

$C_2$: Electrostatic capacity of the second micro tunnel-junction 212

$C_g$: Electrostatic capacity of the parallel plate capacitor 218

Herein, when the bias voltage V is kept at a fixed value and the gate voltage $V_g$ is changed, the electric current I flowing in the single-electron transistor fluctuates periodically.

The period of this fluctuation is as follows.

$$C_g V_g = e$$

Further, the width of fluctuation becomes wider as temperature gets lower, that is, as $k_B T/E_C$ ($k_B$: Boltzman's constant, T: Absolute temperature, $E_C$: Charging energy) is smaller.

Conventionally, in manufacturing a micro tunnel-junction circuit that constitutes the above-described single-electron transistor, a method combining an electron beam lithography and an oblique evaporation method has generally been used (refer to Patent document 1, Non-patent document 3, and Non-patent document 4).

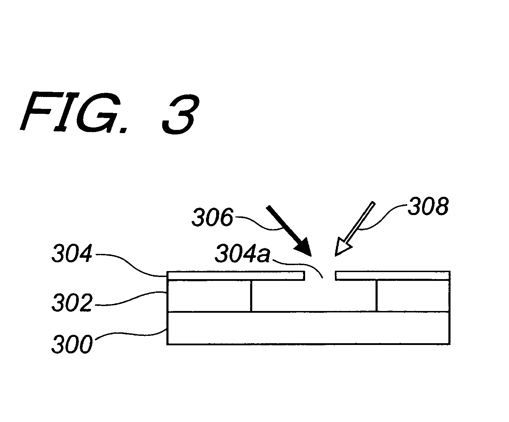

Herein, the method combining the electron beam lithography and the oblique evaporation method will be described, in which the method is that a mask 304 suspended in midair above a substrate 300 is used and evaporation is performed to an opening 304a of a pattern, which is formed in the mask 304, from two different oblique directions as shown in Fig. 3.

In more details, the mask 304 in which the opening 304a of the pattern is formed is arranged on the substrate 300 via a spacer 302, in this method. Consequently, the mask 304 that is elevated above the substrate 300 by the spacer 302 and partially floated in midair is thus prepared.

Next, after performing evaporation 306 of the first metal film from an oblique direction having a certain angle through the opening 304a of the mask 304, the surface of the first metal film is oxidized to form an oxidized film barrier on the first metal film. Further, evaporation 308 of the second metal film is performed through the opening 304a of the mask 304 from an oblique direction having a different angle from that of the evaporation 306 of the first metal film. The evaporation 308 of the second metal film is performed so as to overlap the first metal film in two areas via the oxidized film barrier.

As described, the evaporation 306 of the first metal film and the evaporation 308 of the second metal film are sequentially performed using the opening 304a of the same mask 304 from two different oblique directions, oxidation of the metal film is performed duding the two evaporation processes to form the oxidized film barrier on the first metal film, and thus the micro tunnel-junctions are formed in two areas where the first metal film and the second metal film overlap.

However, the method of manufacturing a micro tunnel-junction circuit using the method combining the electron beam lithography and the oblique evaporation method has had a problem that circuit patterns that can be manufactured were limited and metallic materials that can be used were also limited.

Specifically, there had been a problem that manufacturing fine and complex circuit patterns was difficult by the method of manufacturing a micro tunnel-junction circuit using the method combining the electron beam lithography and the oblique evaporation method.

Further, although there is no problem when the metal evaporated in the oblique evaporation method is aluminum (Al) because aluminum is a relatively light metal, there has been a case where the area floated in midair collapsed by the weight of evaporated metal when a metal heavier than aluminum was used as a metal evaporated in the oblique evaporation method.

Moreover, there has been a problem of drastic quality deterioration in niobium (Nb) or the like due to impurities during evaporation (impurities coming out of mask, for example).

Meanwhile, since the superconductive transition temperature ($T_c$) of niobium is 9.2K whereas the superconductive transition temperature ($T_c$) of aluminum is 1.2K, there is a strong demand for using niobium as a metal that constitutes a micro tunnel-junction circuit.

Non-patent document 1: D.V.Averin and K.K.Likharev, in "Mesoscopic Phenomena in Solids," edited by B.L.Altshuler, P.A.Lee, and R.A.Webb (Elsevier Science B.V. , Amsterdam, 1991), Chap.6.

Non-patent document 2: G.-L.Ingold and Y.V.Nazarov, in "Single Charge Tunneling," edited by H.Grabert and M.H.Devoret (Plenum Press, New York, 1992), Chap.2.

Non-patent document 3: N.Kim et al., "Fabrication of mesoscopic superconducting Nb wires using conventional electron-beam lithographic techniques," J.Vac.Sci.Technol. B20, 386-388(2002).

Non-patent document 4: P.Dubos et al., "Thermostable trilayer resist for niobium lift-off," J.Vac.Sci.Technol. B18, 122-126 (2000) .

Patent document 1: Japanese Patent Laid-open No. 10-107340 publication

Disclosure of the Invention

Problems to be Solved by the Invention

The present invention has been created in view of the background of the invention and the problems that the conventional technologies have, and it is an object of the invention to provide a method of manufacturing a micro tunnel-junction circuit and a micro tunnel-junction circuit, which are capable of remarkably relieving the limitation of a circuit pattern to be manufactured.

Further, it is an object of the present invention to provide a method of manufacturing a micro tunnel-junction circuit and a micro tunnel-junction circuit, which are capable of remarkably relieving the limitation of metallic materials to be used.

Means for Solving the Problems

To achieve the objects, the present invention is that a three-layer structure is formed by laminating a first metal, an insulator, and a second metal on a substrate in this order, a narrow wall part is formed by milling the three-layer structure in the depth direction by using a focused ion beam, at least one laterally passed through-hole is formed in the wall part by using the focused ion beam, and at least one recessed portion positioned adjacent to the hole is formed by milling the upper surface of the wall part in the depth direction, in which the hole is a through-hole starting at the position of the head of the second metal to the position of the head of the substrate, and the recessed portion is formed to be recessed from the upper surface of the wall part into the first metal

Therefore, according to the present invention, the micro tunnel-junction can be formed between the hole and the recessed portion.

Further, the present invention is that a three-layer structure is formed by laminating a first metal, an insulator, and a second metal on a substrate in this order, a narrow wall part is formed by milling the three-layer structure in the depth direction by using a focused ion beam, a laterally passed through-hole is formed in the wall part by using the focused ion beam, and two recessed portions positioned adjacent to the hole so as to sandwich the hole is formed by milling the upper surface of the wall part in the depth direction, in which the hole is a through-hole starting at the position of the head of the second metal to the position of the head of the substrate, and the two recessed portions are formed to be recessed from the upper surface of the wall part into the first metal.

Therefore, according to the present invention, the micro tunnel-junctions can be formed between the hole and the two recessed portions.

Further, the present invention is that a protruded portion is formed by milling the three-layer structure in the depth direction by using a focused ion beam at a position adjacent to the wall and facing the hole and the two recessed portions.

Therefore, according to the present invention, an electrode can be formed adjacent to the two micro tunnel-junctions.

Further, the present invention is that niobium is used as the first metal and the second metal.

Furthermore, the present invention is that xenon fluoride gas is introduced when processing is performed by using the focused ion beam.

Further, the present invention has: a narrow wall part made up of a three-layer structure, which is formed by laminating a first metal, an insulator, and a second metal on a substrate in this order; at least one laterally passed through-hole formed in the wall part; and at least one recessed portion that is formed adjacent to the hole, on the upper surface of the wall part, in which the hole is a through-hole starting at the position of the head of the second metal to the position of the head of the substrate, and the recessed portion is formed to be recessed from the upper surface of the wall part into the first metal.

Therefore, according to the present invention, a micro tunnel-junction circuit in which the micro tunnel-junction is formed between the hole and the recessed portion can be formed.

Further, the present invention has: a narrow wall part made up of a three-layer structure, which is formed by laminating a first metal, an insulator, and a second metal on a substrate in this order; a laterally passed through-hole formed in the wall part; and two recessed portions that are formed adjacent to the hole so as to sandwich the hole, on the upper surface of the wall part, in which the hole is a through-hole starting at the position of the head of the second metal to the position of the head of the substrate, and the two recessed portions are formed to be recessed from the upper surface of the wall part into the first metal.

Therefore, according to the present invention, a micro tunnel-junction circuit in which the micro tunnel-junctions are formed between the hole and the two recessed portions can be formed.

Furthermore, the present invention has a protruded portion that is made up of the three-layer structure, and arranged at a position adjacent to the wall and facing the hole and the two recessed portions.

Therefore, according to the present invention, an electrode can be formed adjacent to the two micro tunnel-junctions.

Still further, the present invention uses niobium as the first metal and the second metal.

Effects of the Invention

Since the present invention is constituted as described above, it exerts an excellent effect that a method of manufacturing a micro tunnel-junction circuit and a micro tunnel-junction circuit, which are capable of remarkably relieving the limitation of a circuit pattern to be manufactured, can be provided.

Further, since the present invention is constituted as described above, it exerts an excellent effect that a method of manufacturing a micro tunnel-junction circuit and a micro tunnel-junction circuit, which are capable of remarkably relieving the limitation of metallic materials to be used, can be provided.

Brief Description of the Drawings

[Fig.1] Fig. 1 is an exemplary view of the principle of a Coulomb blockade phenomenon due to micro tunnel-junction.

[Fig.2] Fig. 2 (a) is a principle constitution view of a single-electron transistor provided with a micro tunnel-junction circuit constituted by the micro tunnel-junction, and Fig. 2(b) shows an equivalent circuit of Fig. 2(a).

[Fig.3] Fig. 3 is an exemplary view of a method of manufacturing a micro tunnel-junction combining an electron beam lithography and an oblique evaporation method.

[Fig.4] Fig. 4 is an exemplary view of the method of manufacturing a micro tunnel-junction circuit according to the present invention, where Fig. 4 (a) shows a constitution of a substrate, Fig. 4(b) shows a constitution of a three-layer structure formed on the substrate, and Fig. 4 (c) is a schematic view when a three-dimensional structure shown in Fig. 5 (c) is viewed from "A" direction of Fig. 4(b).

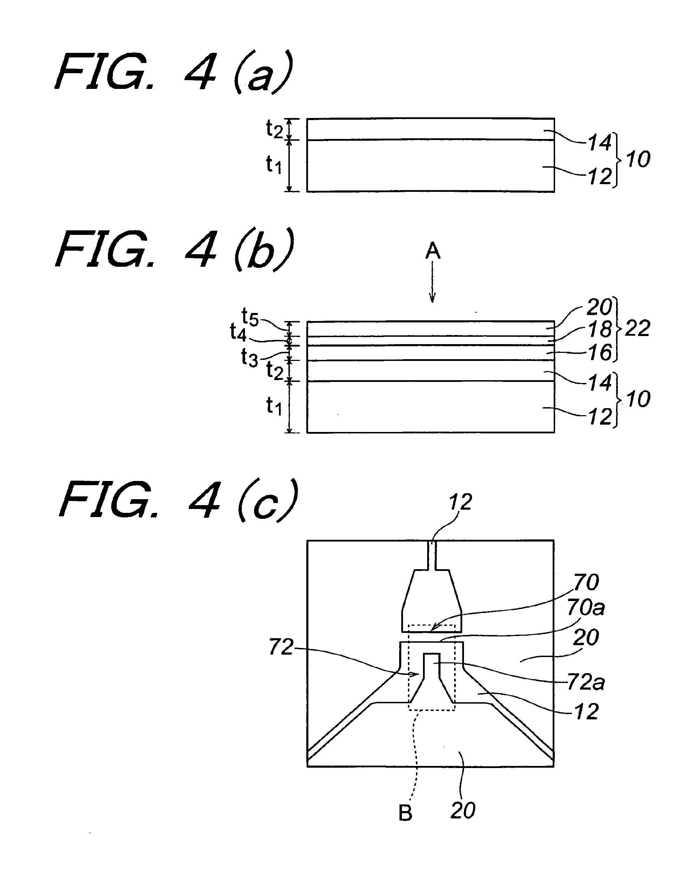

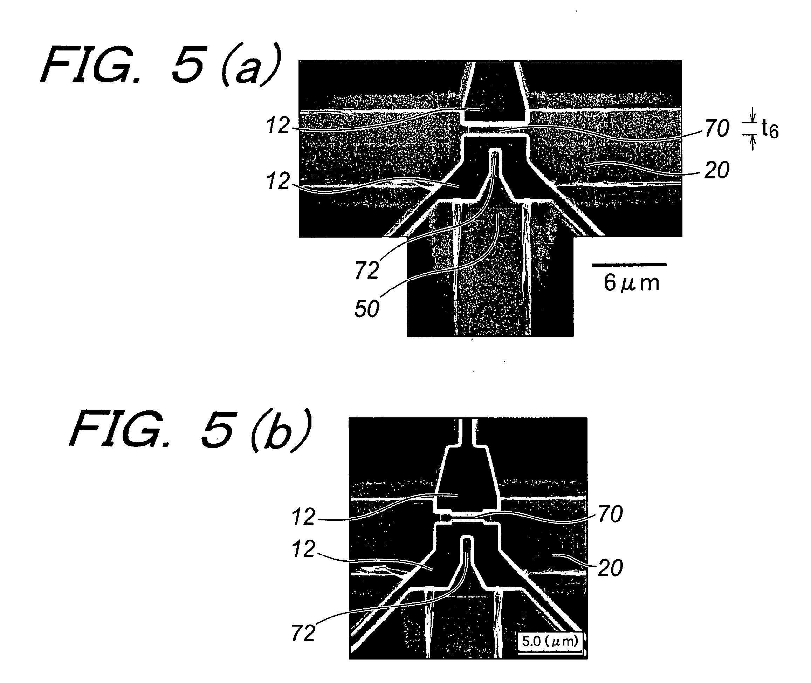

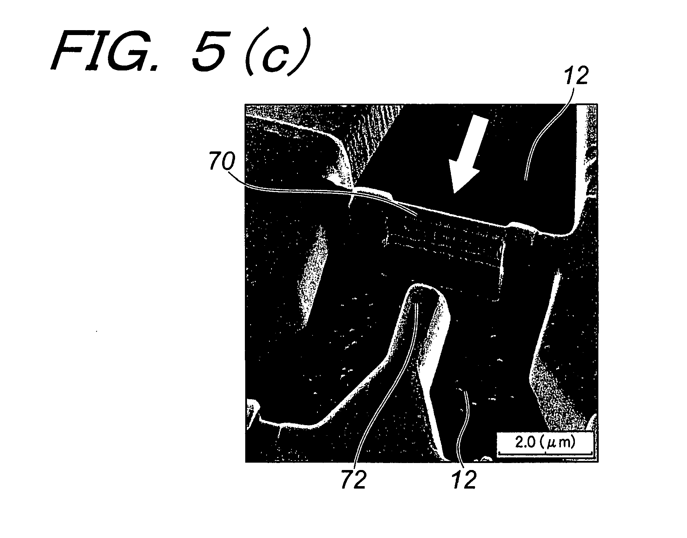

[Fig.5] Fig: 5 (a) and Fig. 5 (b) are exemplary views where the three-dimensional structure is observed by an electron microscope from "A" direction of Fig. 4(b), and Fig. 5(c) is an exemplary view of the three-dimensional structure observed by an electron microscope in a perspective view from upper direction. Fig. 5(a) corresponds to a state where "1. Perform rough milling after laminating carbon protection film", Fig. 5 (b) corresponds to a state where "2. The wall part is made thin", and Fig. 5(c) corresponds to a state where "3. A hole is formed in the wall part and recessed portions are formed".

[Fig.6] Fig. 6(a) is an exemplary view showing enlarged wall part and protruded portion, which is observed by an electron microscope, and Fig. 6 (b) is an equivalent circuit of the micro tunnel-junction circuit constituted by the wall part and the protruded portion.

[Fig.7] Fig. 7(a) is a conceptual constitution exemplary view of a single-electron transistor that is constituted by the micro tunnel-junction circuit constituted by the wall part and the protruded portion, and Fig. 7(b) is an equivalent circuit of Fig. 7 (a).

[Fig.8] Fig. 8 is a graph showing a measurement result of current-voltage characteristics of the single-electron transistor manufactured by the present invention.

[Fig.9] Fig. 9 is a graph showing a measurement result of gate modulation in the case where bias voltage was fixed while gate voltage was varied.

[Fig.10] Fig. 10 is a graph showing a measurement result of current-voltage characteristics for showing temperature dependency of the single-electron transistor manufactured by the present invention.

[Fig.11] In Fig. 11, Fig. 11 (a) is a graph showing variations of differential resistance (dV/dI) in 9.02K and Fig. 11 (b) is a graph showing variations of differential resistance (dV/dI) in 9.18K regarding the single-electron transistor manufactured by the present invention.

[Fig.12] Fig. 12 is a graph showing a measurement result of low-temperature electric conductivity measurement of the single-electron transistor manufactured by the present invention.

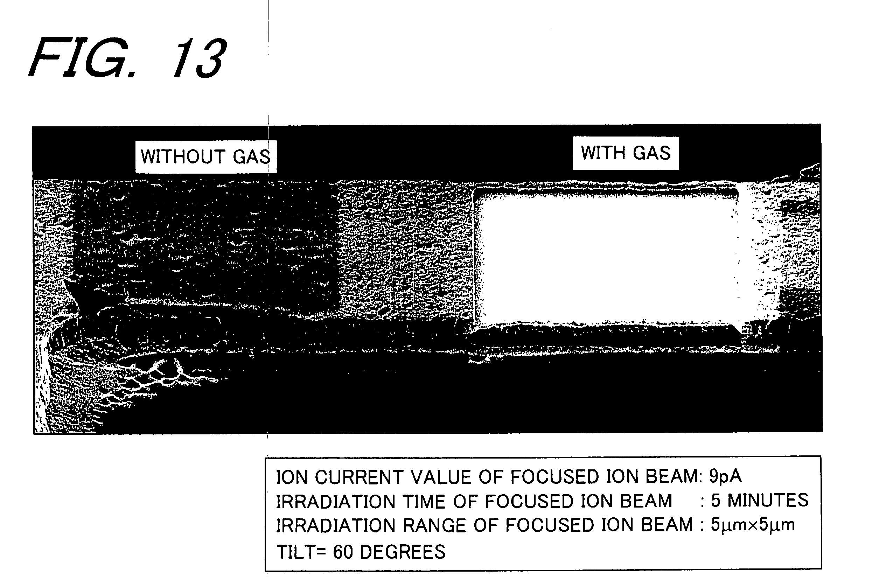

[Fig.13] Fig. 13 is an exemplary view showing an experiment result of an experiment where a three-layer structure of niobium-aluminum-niobium was used as a sample, a focused ion beam having ion current value of 9pA was irradiated on the region of "$5\mu m \times 5\mu m$" being a part of the sample for five minutes to perform milling processing, which was observed by an electron microscope, and the sample was photographed by tilting 60 degrees. The left view (without gas) is the case where xenon fluoride gas was not introduced during the irradiation of the focused ion beam having ion current value of 9pA for five minutes. The right view (with gas) is the case where xenon fluoride gas was introduced during the irradiation of the focused ion beam having ion current value of 9pA for five minutes.

Explanation of Reference Numerals

10 Substrate

12 Silicon (Si) substrate
14 SiO$_2$ substrate
16 Niobium layer
18 Aluminum oxide layer
20 Niobium layer
22 Three-layer structure
50 Carbon protection film
70 Wall part
70a Upper surface
72 Protruded portion
72a Upper surface
80 Hole
82 Recessed portion
84 Recessed portion
90 First micro tunnel-junction
92 Second micro tunnel-junction

Best Mode for Implementing the Invention

In the following, description will be made in details for an embodiment example of the method of manufacturing a micro tunnel-junction circuit and a micro tunnel-junction circuit according to the present invention with reference to the attached drawings.

It is to be noted that the same or equivalent constitutions or contents in the explanation in this specification and the attached drawings will severally be shown by using the same reference numerals, and duplicate explanation regarding their constitutions and operations will be omitted.

Further, in the embodiments described below, description will be made for the case of manufacturing a single-electron transistor made up of a Josephson device of niobium system using niobium as a metal (a device having a structure where a very thin insulation film (thickness is an order of nanometer) is sandwiched by two superconduction thin films is called a Josephson device). It has been confirmed that a manufactured single-electron transistor of niobium system worked accurately as a single-electron transistor and niobium was not deteriorated, as described later.

In the following, description will be specifically made for the case of manufacturing the single-electron transistor made up of the Josephson device of niobium system using niobium as a metal by the method of manufacturing a micro tunnel-junction circuit according to the present invention.

First, a substrate 10 on which an $SiO_2$ film 14 having the thickness $t_2$ of 0.3$\mu$m is formed as an oxide film is prepared on a silicon (Si) substrate 12 having the thickness $t_1$ of 650$\mu$m (refer to Fig. 4 (a)) .

Then, a niobium layer 16 having the thickness $t_3$ of 0.3$\mu$m is formed on the $SiO_2$ film 14 of the substrate 10, an aluminum oxide layer 18 having the thickness $t_4$ of 0.01$\mu$m is formed on the niobium layer 16, and a niobium layer 20 having the thickness $t_5$ of 0.3$\mu$m is formed on the aluminum oxide layer 18 (refer to Fig. 4 (b) . It is to be noted that the aluminum oxide layer 18 is made of aluminum including an $Al_2O_3$ layer having the thickness of 0.001$\mu$m.

Consequently, a three-layer structure 22 of [niobium layer 16 having the thickness of 0.3$\mu$m/aluminum oxide layer 18 having the thickness of 0.01$\mu$m (including an $Al_2O_3$ layer having the thickness of 0.001$\mu$m) /niobium layer 20 having the thickness of 0.03$\mu$m] is thus formed on the $SiO_2$ film 14 of the substrate 10.

It is to be noted that the niobium layer 16 and the niobium layer 20 work as metals in micro tunnel-junction and the aluminum oxide layer 18 works as an insulator in micro tunnel-junction.

Next, the three-layer structure 22 is milled in the arrow A direction (depth direction) on a 10$\mu$m scale by using a method of photolithography and Ar ion milling. Specifically, the three-layer structure 22 formed on the substrate 10 is milled by the method of photolithography and Ar ion milling until the milling reaches the silicon substrate 10 to form a rough three-dimensional structure on a 10$\mu$m scale.

Next, by using a widely known focused ion beam (FIB) system, a focused ion beam output from the focused ion beam system is irradiated on the three-dimensional structure that has been roughly formed on a 10$\mu$m scale, and the three-dimensional structure roughly formed on a 10$\mu$m scale is precisely milled on a 0.1$\mu$m scale.

Herein, the three-dimensional structure formed by milling the three-layer structure 22 with the method of photolithography and Ar ion milling and the irradiation of the focused ion beam is a three-dimensional structure shown in Fig. 5(c) including a wall part 70 and a protruded portion 72. Further, Fig. 4(c) shows the schematic view of the three-dimensional structure shown in Fig. 5 (c) viewed from the A direction.

It is to be noted that the focused ion beam system used in this embodiment is a system in which an ion beam is previously taken out from a gallium ion source and focused into 5 to 10nm first and which is capable of irradiating the ion beam focused, that is, the focused ion beam on a sample (which is the substrate 10 on which the three-layer structure 22 is formed, in this embodiment). With mutual operation of the ion beam and the sample, three functions of "observing function", "milling function" and "attaching function" are realized.

In the above-described embodiment, the "milling function" is used out of the functions. The "milling function" is described that the ion beam is irradiated on the sample by increasing its energy higher than the case of using the beam for the "observing function", the irradiation position of the ion beam to be irradiated on the sample is scanned, and thus it becomes possible to freely milling the sample by the ion beam. By scanning the ion beam only on areas of the sample, which need to be processed, processing into any shape can be performed without using a mask. Then, using the function together with the "observing function", an operation of milling any desired area while observing the area is made possible.

Meanwhile, The "observing function" is described that the sample is excited to emit secondary electrons when a gallium ion beam is irradiated on the sample, the generated secondary electrons are captured while the ion beam is allowed to scan on the sample, and thus the surface condition of the sample can be observed.

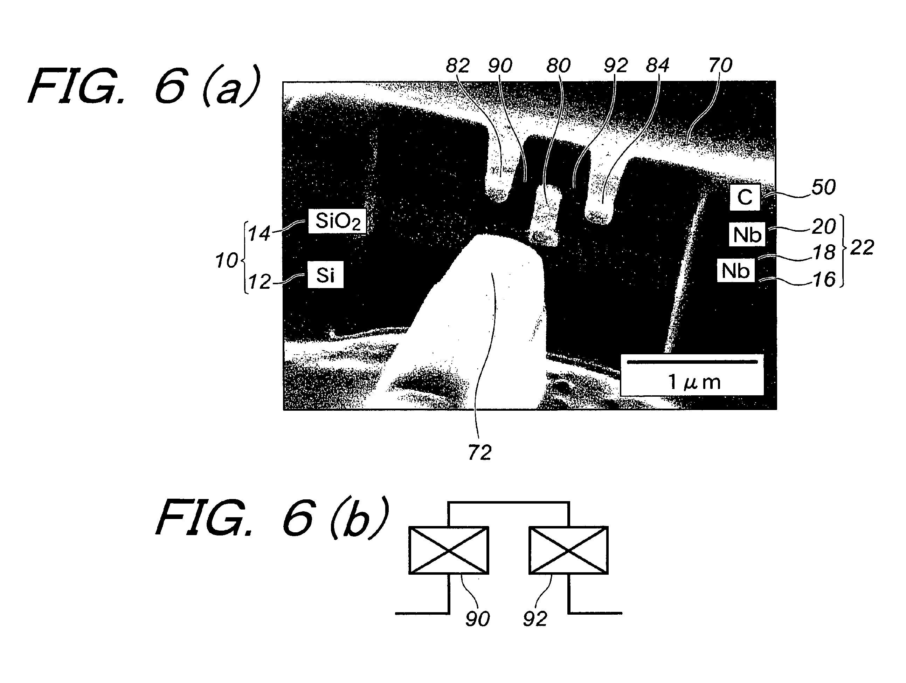

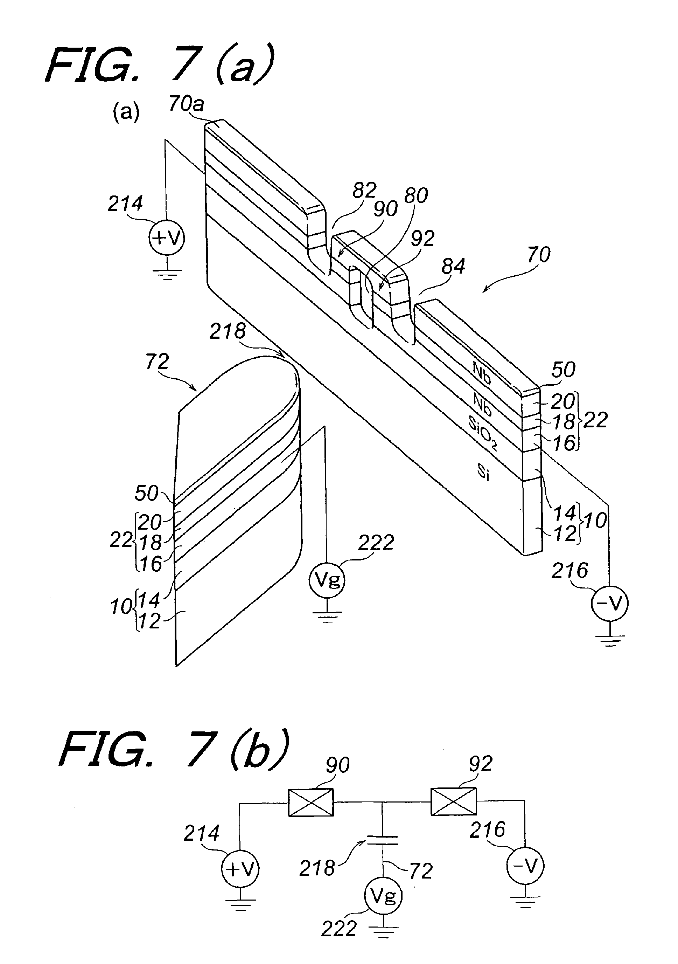

Herein, referring to the exemplary views shown in Figs. 5 (a) (b) (c) and Fig. 6 (a), which show the states where the sample was observed by an electron microscope, description will be made for the details of a process where the three-dimensional structure roughly formed on a 10$\mu$m scale is milled by the focused ion beam on a 0.1$\mu$m scale. It is to be noted that Fig. 5(a) and Fig. 5 (b) are the exemplary views, which were observed by an electron microscope, showing the states where the three-dimensional structure shown in Fig. 5 (c) is viewed from the A direction, and Fig. 5(c) is the exemplary view of the three-dimensional structure observed by an electron microscope in a perspective view from upper direction, and Fig. 6(a) is the exemplary view showing enlarged wall part and protruded portion, which is observed by an electron microscope (Fig. 6 (b) is the equivalent circuit of the micro tunnel-junction circuit constituted by the wall part and the protruded portion), and Fig. 7 (a) is the conceptual constitution exemplary view of the single-electron transistor that is constituted by the micro tunnel-junction circuit constituted by the wall part and the protruded portion (Fig. 7(b) is the equivalent circuit of Fig. 7 (a)) .

First, to prevent a damage of the upper surface 70a of the wall part 70 or the upper surface 72 of the protruded portion 72, which may be caused in performing milling, a carbon protection film 50 is deposited on region B (refer to Fig. 4 (c)) of the upper surface of the three-layer structure 22 of the three-dimensional structure, on which the wall part 70 and the protruded portion 72 are formed, and rough milling is performed after that (refer to Fig. 5(a)). Milling is performed by the rough milling until it reaches the silicon substrate 12 to form the wall part 70 and the protruded portion 72 is formed adjacent to the wall part 70. The ion current value of the focused ion beam during the rough milling is 1.3nA, for example.

Next, milling is performed so as to make the thickness $t_6$ of the wall part 70 narrower, and the thickness $t_6$ of the wall part 70 is set to a thickness on a 0.1$\mu$m scale (refer to Fig. 5 (b) . It is to be noted that the ion current value of the focused ion beam during the milling processing is 9pA, for example.

Next, a hole 80 passing in the thickness $t_6$ direction is formed in the wall part 70, and two recessed portions (82 , 84) by milling the upper surface 70a of the wall part 70 in the arrow A direction (refer to Fig. 5 (c), Fig. 6 (a) and Fig. 7 (a)) . It is to be noted that the ion current value of the focused ion beam during the milling processing is 9pA, for example.

Specifically, the hole 80 and the recessed portions (82, 84) are formed on facing positions to the protruded portion 72, and the hole 80 is a through-hole starting at the position of the head of the niobium layer 20 to the position of the head of the SiO$_2$ film 14. Further, the recessed portions (82, 84) are positioned adjacent to the hole 80 so as to sandwich the hole 80, and the both recessed portions (82, 84) are formed so as to start on the upper surface 70a of the wall part 70 to the head of the niobium layer 16.

Herein, the first micro tunnel-junction 90, where the niobium layer 16 and the niobium layer 20 each being metal sandwich the aluminum oxide layer 18 being the insulator, is formed between the hole and the recessed portion 82, and the second micro tunnel-junction 92, where the niobium layer 16 and the niobium layer 20 each being metal sandwich the aluminum oxide layer 18 being the insulator, is formed between the hole and the recessed portion 84, by which a Josephson device is constituted. Fig. 6(b) shows the equivalent circuit of the above-described first micro tunnel-junction 90 and second micro tunnel-junction 92.

Therefore, as shown in Fig. 7 (a), for example, the first voltage source 214 that applies plus bias voltage V to the niobium layer 16 is connected to the end portion of the recessed portion 82 side of the wall part 70, the second voltage source 216 that applies minus bias voltage V to the niobium layer 16 is connected to the end portion of the recessed portion 84 side of the wall part 70, the third voltage source 222 that applies gate voltage $V_g$ to the niobium layer 16 is connected to the protruded portion 72, and thus the single-electron transistor shown in the equivalent circuit of Fig. 7 (b) can be constituted. It is to be noted that the protruded portion 72 that is formed against the wall 70 with a gap functions as a gate electrode, and the wall 70 and the protruded portion 72 constitute the parallel plate capacitor 218.

Meanwhile, there is a danger that milling shavings, which are produced after forming the wall 70 and the protruded portion 72 by milling the three-layer structure 22 with the method of photolithography and Ar ion milling or the irradiation of the focused ion beam or after forming the hole 80 and the recessed portions (82, 84) in the wall 70, will short-circuit the first micro tunnel-junction 90 and the second micro tunnel-junction 92 that are Josephson junction.

For this reason, in this embodiment, the above-described milling shavings that could short-circuit the Josephson junction being the micro tunnel-junction are anodized into insulators, and the milling shavings are prevented from contributing to electric conductivity. It is to be noted that a conventionally widely known technique can be applied for anodizing milling shavings.

Next, description will be made for the result of measurement that was performed by the single-electron transistor formed as shown in Fig. 7(a).

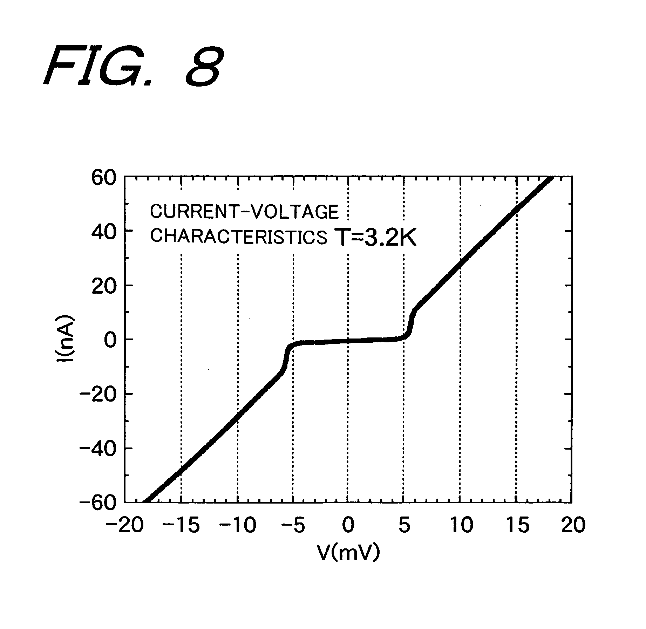

As the current-voltage characteristics of the manufactured single-electron transistor was measured (refer to Fig. 8), a superconducting gap (flat area in center) is observed, and its width corresponds to the amount of two micro tunnel-junctions of niobium. Therefore, the graph shows that a double superconduction tunnel-junction of the first micro tunnel-junction 90 and the second micro tunnel-junction 92 is created in the manufactured single-electron transistor.

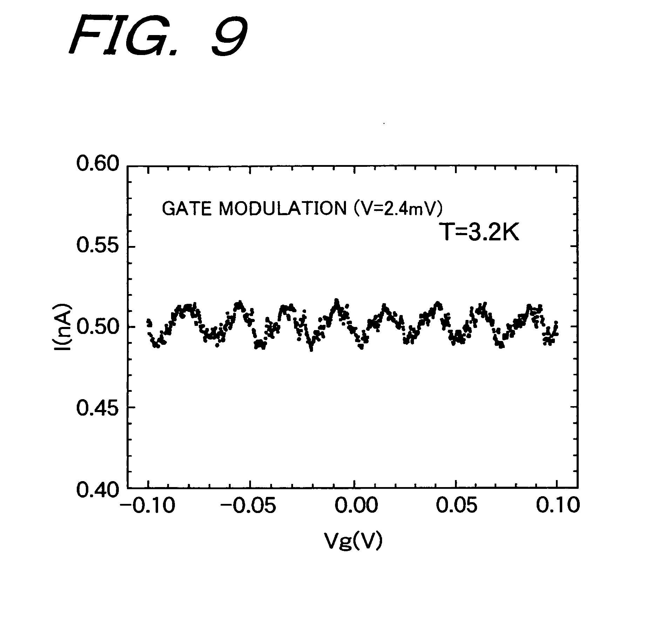

Further, the current varies periodically when the gate voltage is changed while the bias voltage is fixed (refer to fig. 9). Therefore, the graph shows that the gate functions in the manufactured single-electron transistor.

With these graphs, it has been confirmed that the single-electron transistor using niobium as a metal was created.

It is to be noted that a simple freezer was used in the above-described measurement. At the lowest temperature (3.2K) of the simple freezer, $k_BT$ and $E_C$ are approximately the same. Accordingly, a modulation width of the gate modulation observed is small.

Herein, it is known that the superconductive transition temperature ($T_c$) and the superconducting gap of deteriorated niobium become smaller than those of bulk niobium. Report has been made for such deterioration caused in a niobium film manufactured by using the method combining the electron beam lithography and the oblique evaporation method.

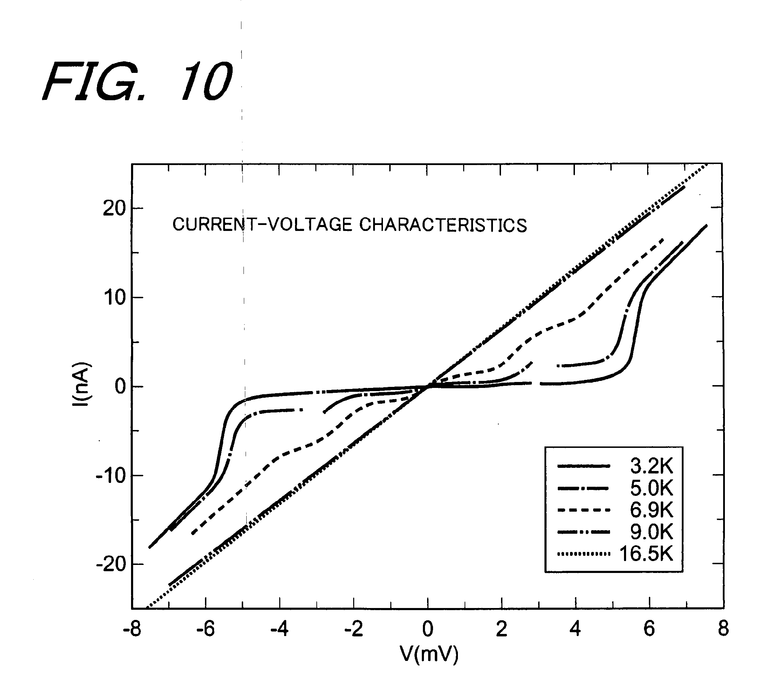

Then, by inspecting the temperature dependency of the manufactured single-electron transistor, the quality of the manufactured single-electron transistor is evaluated (refer to Fig. 10).

Specifically, the superconducting gap at the lowest temperature is slightly less than 3mV per one micro tunnel-junction. This value is approximately the same as a value of a high-quality micro tunnel-junction manufactured by photolithography.

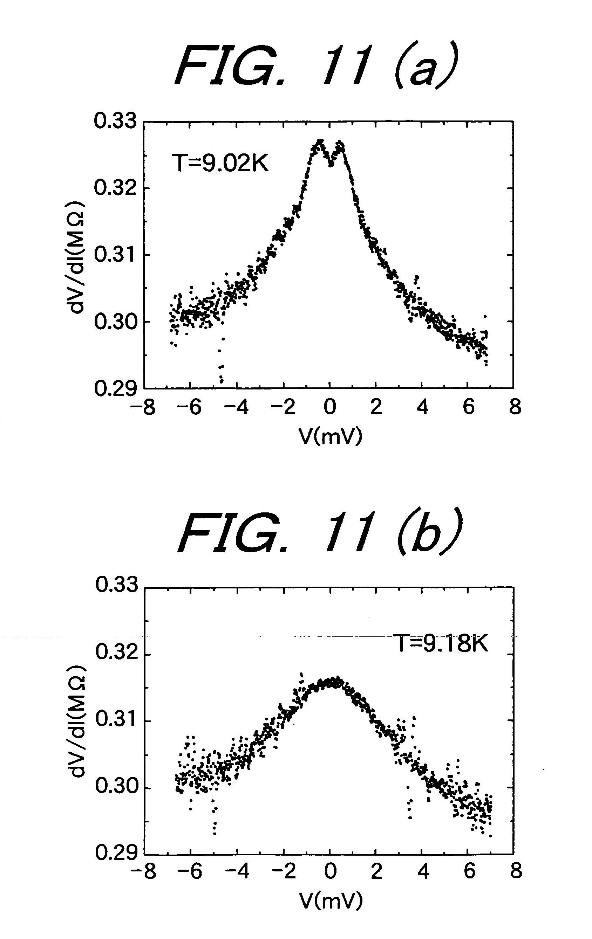

Further, the superconductive transition temperature ($T_c$) obtained by examining the differential resistance (dV/dI) is 9.1$\pm$0.2K (refer to Figs. 11(a)(b)). The value is within the range of error and matches 9.2K being the value of the superconductive transition temperature ($T_c$) of bulk. These graphs show that high-quality niobium without deterioration in the process of manufacturing was obtained in the manufactured single-electron transistor.

Meanwhile, the details of analysis regarding the differential resistance (dV/dI) is as follows. Specifically, Figs. 11(a)(b) are graphs of differential resistance-voltage at 9.02K (Fig. 11 (a)) and 9.18K (Fig.11 (b)). Since a quality difference between the two drawings is obvious, it is considered that there is a superconductive transition temperature ($T_c$) between 9.02K and 9.18K, and the following can be concluded taking an error of thermometer in consideration.

$$T_c = 9.1 \pm 0.2K$$

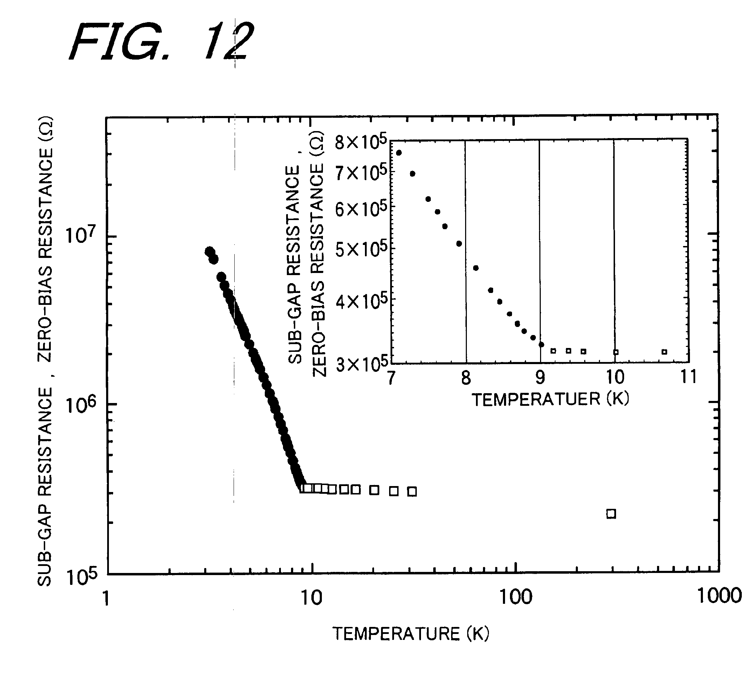

Furthermore, Fig. 12 shows plotted temperature function of sub-gap resistance in the low temperature side and zero-bias resistance in the high temperature side by using the superconductive transition temperature ($T_c$) as a boundary. This proves that the determination of the superconductive transition temperature ($T_c$) referring to Figs. 10(a)(b) is reasonable. It is to be noted that the sub-gap resistance was defined as the maximum value of V/I. In addition, the zero-bias resistance may be considered as the differential resistance at V=O.

It is to be noted that the above-described embodiment may be appropriately modified as described in the following (1) to (6).

(1) In the above-described embodiment, the two recessed portions (82, 84) were formed so as to sandwich the hole 80. However, the recessed portions are not limited to two positions but only one of the recessed portion 82 and the recessed portion 84 may be formed. In addition, the first voltage source 214 may be connected to the niobium layer 16 and the second voltage source 216 may be connected to the niobium layer 20 when only the recessed portion 82 is formed, for example. On the other hand, the first voltage source 214 may be connected to the niobium layer 20 and the second voltage source 216 may be connected to the niobium layer 16 when only the recessed portion 84 is formed, for example.

In short, by forming a recessed portion(s) such as the recessed portion 82 and the recessed portion 84 adjacent to a hole(s) formed like the hole 80 in the wall part 70, a micro tunnel-junction is formed between the hole (s) and the recessed portion(s), so that the number of the holes and the recessed portions is not particularly limited in the present invention. For example, when a plurality of holes are formed in the wall, one recessed portion can be formed adjacent to the hole with respect to each hole or two recessed portions can be formed adjacent to the hole with respect to each hole while sandwiching it. Meanwhile, when each voltage source is connected to the three-layer structure 22, a layer to which the source is connected may be appropriately changed.

(2) In the above-described embodiment, niobium was used as the metal in the micro transistor-junction. However, it goes without saying the invention is not limited to this, and other metals such as aluminum may be naturally used.

(3) In the above-described embodiment, aluminum oxide was used as the insulator in the micro transistor-junction. However, it goes without saying the invention is not limited to this, and other metal oxide may be naturally used.

(4) In the above-described embodiment, description was made for a single-electron transistor as an example of the micro transistor-junction circuit, it goes without saying the invention is not limited to this, and various micro tunnel-junction circuits can be manufactured.

(5) In the above-described embodiment, the three-layer structure 22 was milled by the method of photolithography and Ar ion milling or the irradiation of a focused ion beam to form the wall 70 or the protruded portion 72, and the milling shavings produced after forming the wall 70, the protruded portion 72 and the recessed portions (82, 84) were anodized into an insulator and the possibility of short-circuit due to the milling shavings in Josephson junction being the micro tunnel-junction was eliminated. In the case where xenon fluoride ($XeF_2$) gas is introduced when milling processing is performed by the irradiation of the focused ion beam, the thickness of niobium, which needs to be anodized into insulator, can be made thinner, and as a result, the accuracy of micro tunnel-junction can be improved.

Meanwhile, the introduction of xenon fluoride gas when milling processing is performed by the irradiation of focused ion beam can be made immediately before the process of anodizing the milling shavings, for example.

As it is obvious from the experiment result conducted by the present inventors, which will be explained below, when the milling processing by the irradiation of focused ion beam is performed while xenon fluoride gas is introduced, processing speed of niobium (Nb) is remarkably accelerated (specifically, it is the speed 100 times or higher the case where xenon fluoride gas is not introduced), whereas the processing speed of aluminum (A1) hardly changes. Its reason is believed that xenon fluoride gas chemically reacted with niobium and removed niobium.

Therefore, by milling the vicinity of the micro tunnel-junction with the irradiation of a very weak focused ion beam while xenon fluoride gas is introduced before anodizing the milling shavings as described above, most milling shavings that short-circuit the micro tunnel-junction can be removed.

With this, the thickness of niobium, which needs to be anodized into insulator, can be made thinner, and as a result, the accuracy of micro tunnel-junction can be improved.

Meanwhile, the experiment conducted by the present inventors is as follows. Specifically, a three-layer structure same as the three-layer structure 22 of niobium-aluminum-niobium, which was used in the above-described embodiment, was prepared, and milling processing was performed by irradiating a focused ion beam having the ion current value of 9pA on a region "5μm×5μm" being a part of the structure for five minutes. It is to be noted that the irradiation of the focused ion beam having the ion current value of 9pA for five minutes was performed to the two cases where xenon fluoride gas was not introduced and xenon fluoride gas was introduced. First, description will be made for the case where xenon fluoride gas was not introduced. Since the current value being the ion current value of 9pA is very weak, almost no change was created on the surface of the three-layer structure on which the focused ion beam was irradiated, that is, a niobium layer (refer to the left image (without gas) of Fig. 13).

On the other hand, in the case where milling processing was performed while xenon fluoride gas was introduced, the niobium layer on the surface of the three-layer structure was completely removed, and an aluminum layer was exposed on surface (refer to the right image (with gas) of Fig. 13) . Although the aluminum layer is very thin comparing to the niobium layer, almost no change is found on the aluminum layer.

Consequently, experiment shows that, when xenon fluoride gas is introduced while the focused ion beam is irradiated, the milling speed of niobium is accelerated remarkably but aluminum hardly changes.

(6) The above-described embodiment and the modifications shown in (1) to (5) may be combined appropriately.

Industrial Applicability

The present invention is applicable to various micro tunnel-junction circuits such as a single-electron transistor that is known as an electronic device for realizing charge measurement and quantum computation.

**Claims**

1.  A method of manufacturing a micro tunnel-junction circuit, said method comprising the steps of:

    forming a three-layer structure by laminating a first metal, an insulator, and a second metal on a substrate in this order;
    forming a narrow wall part by milling said three-layer structure in the depth direction by using a focused ion beam; and
    forming at least one laterally passed through-hole in said wall part by using the focused ion beam, and forming at least one recessed portion positioned adjacent to said hole by milling the upper surface of said wall part in the depth direction, wherein
    said hole is a through-hole starting at the position of the head of the second metal to the position of the head of said substrate, and said recessed portion is formed to be recessed from the upper surface of said wall part into the first metal.

2.  A method of manufacturing a micro tunnel-junction circuit, said method comprising the steps of:

    firming a three-layer structure by laminating a first metal, an insulator, and a second metal on a substrate in this order;
    forming a narrow wall part by milling said three-layer structure in the depth direction by using a focused ion beam; and
    forming a laterally passed through-hole in said wall part by using the focused ion beam, and forming two recessed portions positioned adjacent to said hole so as to sandwich said hole by milling the upper surface of said wall part in the depth direction, wherein
    said hole is a through-hole starting at the position of the head of the second metal to the position of the head of said substrate, and said two recessed portions are formed to be recessed from the upper surface of said wall part into the first metal.

3.  The method of manufacturing a micro tunnel-junction circuit according to Claim 2, said method further comprising the step of:

    forming a protruded portion by milling said three-layer structure in the depth direction by using the focused ion beam at a position adjacent to said wall and facing said hole and said two recessed portions.

4.  The method of manufacturing a micro tunnel-junction circuit according to any one of Claims 1, 2 and 3, wherein
    said first metal and said second metal are niobium.

5.  The method of manufacturing a micro tunnel-junction circuit according to Claim 4, wherein
    xenon fluoride gas is introduced when processing is performed by using said focused ion beam.

6.  A micro tunnel-junction circuit, comprising:

a narrow wall part made up of a three-layer structure which is formed by laminating a first metal, an insulator, and a second metal on a substrate in this order;

at least one laterally passed through-hole formed in said wall part; and

at least one recessed portion that is formed adjacent to the hole, on the upper surface of said wall part, wherein

said hole is a through-hole starting at the position of the head of the second metal to the position of the head of said substrate, and said recessed portion is formed to be recessed from the upper surface of said wall part into the first metal.

7. A micro tunnel-junction circuit, comprising:

a narrow wall part made up of a three-layer structure, which is formed by laminating a first metal, an insulator, and a second metal on a substrate in this order;

a laterally passed through-hole formed in said wall part; and

two recessed portions that are formed adjacent to said hole so as to sandwich said hole, on the upper surface of said wall part, wherein

said hole is a through-hole starting at the position of the head of the second metal to the position of the head of said substrate, and said two recessed portions are formed to be recessed from the upper surface of said wall part into the first metal.

8. The micro tunnel-junction circuit according to Claim 7, further comprising:

a protruded portion that is made up of said three-layer structure, and arranged at a position adjacent to said wall and facing said hole and said two recessed portions.

9. The micro tunnel-junction circuit according to any one of Claims 6, 7 and 8, wherein said first metal and said second metal are niobium.

# *FIG. 1*

106

ELECTRON

100

104

102

## FIG. 2 (a)

## FIG. 2 (b)

# FIG. 3

306
308
304
304a
302
300

# FIG. 4 (a)

# FIG. 4 (b)

# FIG. 4 (c)

FIG. 5 (a)

FIG. 5 (b)

# FIG. 5 (c)

2.0 (μm)

EP 1 653 525 A1

## FIG. 6 (a)

82  90    80    92  84    70

C — 50

SiO₂ — 14

Nb — 20 ⎫
18 ⎬ 22
Nb — 16 ⎭

Si — 12

10

1 μm

72

## FIG. 6 (b)

90    92

# FIG. 7 (a)

# FIG. 7 (b)

# FIG. 8

CURRENT-VOLTAGE CHARACTERISTICS T=3.2K

# FIG. 9

FIG. 10

CURRENT-VOLTAGE CHARACTERISTICS

| | |
|---|---|
| —— | 3.2K |
| —·—· | 5.0K |
| - - - - | 6.9K |
| —··—·· | 9.0K |
| ·········· | 16.5K |

EP 1 653 525 A1

## FIG. 11 (a)

## FIG. 11 (b)

FIG. 12

EP 1 653 525 A1

# FIG. 13

ION CURRENT VALUE OF FOCUSED ION BEAM: 9pA
IRRADIATION TIME OF FOCUSED ION BEAM　: 5 MINUTES
IRRADIATION RANGE OF FOCUSED ION BEAM : 5μm×5μm
TILT= 60 DEGREES

<div align="center">

### INTERNATIONAL SEARCH REPORT

</div>

| | International application No. |
|---|---|
| | PCT/JP2004/011071 |

**A. CLASSIFICATION OF SUBJECT MATTER**
Int.Cl$^7$ H01L39/24, H01L39/22, H01L29/66

According to International Patent Classification (IPC) or to both national classification and IPC

**B. FIELDS SEARCHED**

Minimum documentation searched (classification system followed by classification symbols)
Int.Cl$^7$ H01L39/24, H01L39/22, H01L29/66

Documentation searched other than minimum documentation to the extent that such documents are included in the fields searched
Jitsuyo Shinan Koho          1926–1996    Jitsuyo Shinan Toroku Koho    1996–2004
Kokai Jitsuyo Shinan Koho    1971–2004    Toroku Jitsuyo Shinan Koho    1994–2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | KIM S.-J. and YAMASHITA T., "Fabrication and characteristics of submicron tunneling junctions on high Tc superconducting c-axis thin films and single crystals", J of Appl.Phys., Vol.89, No.11, 01 June, 2001 (01.06.01), pages 7675 to 7677; Figs. 1 to 4 | 1-9 |
| A | BURNELL G. et al., "Nanoscale superconductor-normal metal-superconductor junctions fabricated by focused ion beam", Physca C, Vol.372 to 378, 2002, pages 14 to 17; Fig. 1 | 1-9 |
| A | JP 10-294499 A (Sumitomo Electric Industries, Ltd.), 04 November, 1998 (04.11.98), Figs. 1 to 4 (Family: none) | 1-9 |

☒ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 01 November, 2004 (01.11.04) | 16 November, 2004 (16.11.04) |

| Name and mailing address of the ISA/<br>Japanese Patent Office | Authorized officer |
|---|---|
| Facsimile No. | Telephone No. |

Form PCT/ISA/210 (second sheet) (January 2004)

**INTERNATIONAL SEARCH REPORT**

| International application No. |
| --- |
| PCT/JP2004/011071 |

C (Continuation).   DOCUMENTS CONSIDERED TO BE RELEVANT

| Category* | Citation of document, with indication, where appropriate, of the relevant passages | Relevant to claim No. |
| --- | --- | --- |
| E,A | JP 2004-296677 A  (Independent Administrative Institution National Institute for Materials Science), 21 October, 2004 (21.10.04), Figs. 1 to 4 (Family: none) | 1-9 |

Form PCT/ISA/210 (continuation of second sheet) (January 2004)